# EUROPÄISCHE PATENTSCHRIFT

(11) **EP 1 101 750 B1**
(45) Veröffentlichungstag und Bekanntmachung des Hinweises auf die Patenterteilung: **03.12.2003**
(21) Anmeldenummer: 00890288.4
(22) Anmeldetag: 20.09.2000
(51) Int. Cl.: C04B 37/02

(54) **Verfahren zur Vorbereitung eines AIuminiumnitridsubstrates auf die Verbindung mit einer Kupferschicht**
Method of preparing an aluminum nitride substrate for bonding with a copper layer
Procédé de préparation d'un substrat en nitrure d'aluminium pour l'assemblage avec une couche en cuivre

(30) Priorität: 17.11.1999 AT 194599
(43) Veröffentlichungstag der Anmeldung: 23.05.2001
(73) Patentinhaber: ELECTROVAC, FABRIKATION ELEKTROTECHNISCHER SPEZIALARTIKEL GESELLSCHAFT M.B.H., 3400 Klosterneuburg (AT)
(72) Erfinder: Topitsch, Herbert Dr., 1030 Wien (AT)
(74) Vertreter: Gibler, Ferdinand, Dipl.Ing. Dr. techn.

(56) Entgegenhaltungen:
- EP-A- 0 170 012
- DE-A- 4 104 860
- W.L. CHIANG ET AL.: "Effect of substrate and pretreatment on copper to AlN direct bonds" CERAMIC ENGINEERING AND SCIENCE PROCEEDINGS, Bd. 12, Nr. 9/10, 1991, Seiten 2105-2114, XP000266408 Westerville, OH, US
- DATABASE WPI Week 199833 Derwent Publications Ltd., London, GB; AN 1998-381202 XP002157833 & JP 10 152384 A (SUMITOMO KINZOKU CERAMICS KK), 9. Juni 1998 (1998-06-09)

## Beschreibung

Die Erfindung betrifft ein Verfahren zur Vorbereitung eines AIN-Substrates auf die Verbindung mit einer Kupferschicht mittels eines Direct-Copper-Bonding- (DCB- )Verfahrens, wobei auf der mit der Kupferschicht zu verbindenden Oberfläche des AlN-Substrates Al₂O₃ durch Erhitzen des AlN-Substrates in sauerstoffhältiger Atmosphäre gebildet wird, in welcher Atmosphäre ein Sauerstoff-Überangebot hergestellt wird.

Im Stand der Technik ist es bekannt, eine Kupferschicht auf einem keramischen Substrat mittels eines Direct-Copper-Bonding- (DCB-)Verfahrens festzulegen. Dabei existiert sowohl das keramische Substrat als auch die Kupferschicht ―diese in Gestalt einer dünnen Kupferfolie- bereits vor Durchführung des Verfahrens. Mittels des DCB-Verfahrens wird die Kupferfolie mit der Oberfläche des Substrates verbunden.

Bei einem solchen Direct-Copper-Bonding- (DCB-)Verfahren wird zwischen dem keramischen Substrat und der Kupferfolie durch Aufbringen von Sauerstoff auf eine dieser beiden Komponenten und/oder beide Komponenten und nachfolgendes Erhitzen über die eutektische Temperatur von Cu und Cu₂O ein Cu/Cu₂O-Eutektikum gebildet, welches nach Abkühlen der beiden Komponenten diese miteinander verbindet. Bei der auf diese Weise erfolgenden Herstellung eines Kupfer-Keramik-Verbundes wird die physikalische Tatsache ausgenutzt, daß ein Cu/Cu₂O-Eutektikum sowohl Kupfer als auch Keramik sehr gut benetzt bzw. daß dieses Eutektikum nach dem Erkalten besonders gut an Keramik und Kupfer haftet und somit diese beiden Komponenten besonders innig miteinander verbindet.

Besagtes DCB-Verfahren ist besonders gut zur Bondung von Kupferschichten auf Al₂O₃-Substraten geeignet, weil bei diesen Keramiken der zur Bildung des Cu/Cu₂O-Eutektikums notwendige Sauerstoff auf der Oberfläche des Substrates bereits vorhanden ist und somit keine zusätzlichen Maßnahmen zur Aufbringung dieses Sauerstoffes gesetzt werden müssen.

Substrate, auf welchen Kupferschichten mittels des DCB-Verfahren gebondet sind, werden beispielsweise eingesetzt als Leiterplatten zur Aufnahme von Hochleistungsbaugruppen, wie z.B. Gleichrichterschaltungen umfassend IGBTs zur Bereitstellung von Gleichspannung für Gleichstrommaschinen. Bei diesen Anwendungen ist auf der ersten Oberfläche eine großflächige, im allgemeinen vollflächig durchgängig ausgebildete Kupferschicht aufgebondet, auf welcher ein Kühlkörper befestigt werden kann und sind auf der zweiten Oberfläche Kupferschichten in Gestalt von Leiterbahnen zur Verbindung der einzelnen Leistungsbauteile aufgebondet.

Insbesondere in diesem Anwendungsbereich besteht der Bedarf, das keramische Substrat aus AIN zu bilden. Das Aufbonden von Kupfer auf die Oberflächen eines solchen Materials ist insofern schwieriger als das Aufbonden von Kupfer auf Al₂O₃-Substrate, weil eine AlN-Oberfläche selbst keinen Sauerstoff beinhaltet und dieser durch zusätzliche Verfahrensschritte, beispielsweise durch Anbringen eines entsprechenden Katalysators, auf die AlN-Oberfläche aufgebracht werden muß.

Um das Verwenden derartiger Katalysatoren zu vermeiden, ist im Stand der Technik bereits vorgeschlagen worden, jene Oberfläche eines AlN-Substrates, auf welche eine Kupferschicht aufgebondet werden soll, zu oxidieren, sodaß an dieser Oberfläche Al₂O₃ entsteht, auf welchem Material ein DCB-Verfahren durchgeführt werden kann.

Im Stand der Technik wird dazu das AlN-Substrat bei Normalluft-Atmosphäre auf Temperaturen im Bereich zwischen etwa 1000°C und 1400°C aufgeheizt. Dabei reagiert der in der Luft enthaltene Sauerstoff mit dem oberflächlichen Al des Substrates, wobei Al₂O₃ an der Substrat-Oberfläche gebildet wird.

Nachteilig ist bei diesem Verfahren insbesondere der langsame Ablauf des Oxidationsprozesses, was bedingt, daß das Substrat sehr lange auf der erhöhten Temperatur gehalten werden muß: Bei Aufheizung des AlN-Substrates auf die erwähnten Temperaturen von 1000°C bis 1400°C werden im Stand der Technik Zeitdauern von einer halben Stunde (bei 1400°C) bis zehn Stunden (bei 1000°C) angegeben.

Dieses lange Halten der erörterten hohen Temperatur ist einerseits sehr energieaufwendig und führt andererseits dazu, daß der gesamte DCB-Prozeß zur Aufbringung einer Kupferschicht auf ein AlN-Substrat sehr lange dauert und damit kostenaufwendig ist.

In der **EP-A2-170 012** wird ein Metall-Keramik-Verbundelement beschrieben, das ein aus Nitridkeramik, wie z.B. AlN oder Si₃N₄ gebildetes Substrat umfaßt. Auf diesem Substrat liegt eine Oxidschicht, auf welcher über eine eutektische Zwischenschicht eine Metallschicht festgelegt ist. Zur Herstellung der Oxidschicht wird das Keramiksubstrat auf Temperaturen zwischen 1100°C und 1300°C für eine Zeit von 5 bis 60 Minuten aufgeheizt. Die das Substrat dabei umgebende Atmosphäre kann durch reinen Sauerstoff gebildet sein. Es stehen dadurch bei gleichbleibend großer AlN-Oberfläche mehr Sauerstoffatome als im oben erörterten Stand der Technik zur Verfügung, womit die Ausbildung einer deckenden Al₂O₃-Schicht auf der AlN-Oberfläche schneller ablaufen kann.

Es ist Aufgabe der vorliegenden Erfindung, ein Verfahren zur Vorbereitung eines AlN-Substrates auf die Verbindung mit einer Kupferschicht mittels eines Direct-Copper-Bonding-(DCB-) Verfahrens anzugeben, wobei auf der mit der Kupferschicht zu verbindenden Oberfläche des AlN-Substrates Al₂O₃ durch Erhitzen des AlN-Substrates in sauerstoffhältiger, ein Sauerstoff-Überangebot enthaltender Atmosphäre gebildet wird, bei welchem Verfahren das Sauerstoff-Überangebot auf technisch besonders einfache Weise hergestellt werden kann.

Erfindungsgemäß wird dies dadurch erreicht, daß das Sauerstoff-Überangebot durch Setzen einer sauerstoffhältigen Atmosphäre unter Überdruck, vorzugsweise im Bereich zwischen 1,2 und 10 bar, hergestellt wird.

Es kann hier völlig ohne Zugabe von Gasen zur Normal-Luftatmosphäre gearbeitet werden. Dennoch wird erreicht, daß im Ofeninnenraum mehr Sauerstoffatome zur Verfügung stehen als bei Normaldruck, sodaß zuverlässig eine Beschleunigung der oberflächlichen Oxidation der AlN-Oberfläche erreicht wird.

Gemäß einer ersten Ausführungsform der Erfindung kann vorgesehen sein, daß in die Atmosphäre O₂ zugegeben wird oder daß die Atmosphäre zur Gänze durch O₂ gebildet wird.

Dies ist mit besonders geringem technischen Aufwand verbunden realisierbar, da O₂ als solches bereits am Markt erhältlich ist. Zur Ausführung dieser Erfindungsvariante braucht dieses Gas lediglich in den Ofen, in welchem das AlN-Substrat erhitzt wird, eingelassen werden.

Gemäß einer anderen Ausführungsform der Erfindung kann vorgesehen sein, daß in die Atmosphäre O₃ zugegeben wird oder daß die Atmosphäre zur Gänze durch O₃ gebildet wird.

Auch dieses Gas ist am Markt erhältlich bzw. kann durch UV-Bestrahlung der normalen Umgebungsatmosphäre hergestellt und anschließend in den Ofen eingeleitet werden.

In weiterer Ausgestaltung der Erfindung kann vorgesehen sein, daß das AlN-Substrat für eine Zeitdauer zwischen 1 und 20 min erhitzt wird.

Es bildet sich dabei eine relativ dicke Al₂O₃-Schicht (5-15µm), welche gut zur Anbindung einer Kupferschicht mittels DCB-Verfahren geeignet ist.

Es hat sich als besonders günstig erwiesen, daß das AlN-Substrat für eine Zeitdauer zwischen 1 und 20s erhitzt wird.

Bei solch kurzen Reaktionszeiten entstehen nur relativ dünne Al₂O₃-Schichten. Kupferschichten können auf derartige Al₂O₃-Schichten besonders homogen angebunden werden, was zu einer besonders guten Bondung der Kupferschicht am AlN-Substrat führt.

Die Erfindung wird nachstehend näher beschrieben.

Sie geht von einem im Stand der Technik grundsätzlich bereits bekannten Verfahren zur Vorbereitung eines AlN-Substrates auf die Verbindung mit einer Kupferschicht mittels eines Direct-Copper-Bonding- (DCB-)Verfahrens aus. Gemäß diesem Vorbereitungs-Verfahren ist vorgesehen, auf jener Oberfläche des AlN-Substrates, welche mit der Kupferschicht verbunden werden soll, eine Schicht aus Al₂O₃ auszubilden. Auf einem solchen keramischen Material können Kupferschichten besonders einfach, insbesondere ohne Verwendung von Katalysatoren, mittels eines DCB-Verfahrens festgelegt werden.

Die Ausbildung von Al₂O₃ auf der AlN-Oberfläche erfolgt durch Erhitzen des A1N-Substrates in sauerstoffhältiger Atmosphäre auf solche Temperaturen (etwa 1000°C bis 1400°C), bei welchen AlN mit dem Sauerstoff der umgebenden Atmosphäre reagiert. Dabei bildet sich besagtes Al₂O₃ sowie N₂, das in die Umgebungsatmosphäre abgegeben wird.

Um einen besonders schnellen Ablauf dieser Oxidationsreaktion zu erreichen, ist erfindungsgemäß vorgesehen, in der das AlN-Substrat umgebenden Atmosphäre ein Sauerstoff-Überangebot herzustellen, durch setzen der Umgebungs-Atmosphäre des AlN-Substrates unter Überdruck, beispielsweise im Bereich zwischen 1,2 und 10 bar.

Es kann durch eine mit O₂ oder mit O₃ angereicherte bzw. aus O₂ oder O₃ gebildete Atmosphäre unter Überdruck gesetzt werden.

Die konkret eingesetzten Prozeßparameter (Temperatur, Atmosphärenzusammensetzung, Atmosphärendruck und Reaktionszeit) müssen stets so ausgewählt und aufeinander abgestimmt werden, daß auf der Oberfläche des AlN-Substrates eine Al₂O₃-Schicht mit einer Dicke im Bereich zwischen 0,1 und 15µm ausgebildet wird, um die Bondung einer Kupferschicht auf dem Substrat mittels nachfolgendem DCB-Verfahren zu ermöglichen.

Ohne die Erfindung darauf zu beschränken, können abschließend die folgenden Verfahrensparameter angegeben werden, unter Anwendung welcher das erfindungsgemäße Verfahren ausgeführt wurde:

### Vergleichs beispiel 1: Temperatur: 1250°C, Atmosphärenzusammensetzung: reines O₃, Atmosphärendruck: 1bar, Reaktionsdauer: 10min

### Beispiel 2: Temperatur: 1275°C, Atmosphärenzusammensetzung: Umgebungsluft (23,06 Gew.-% O₂); Atmosphärendruck 3bar, Reaktionszeit: 15min

In beiden Fällen bildete sich eine die gesamte AlN-Oberfläche durchgängig bedeckende Al₂O₃-Beschichtung, welche Dicken in Bereich zwischen 10 und 15µm aufwies.

Im nach Abschluß des erfindungsgemäßen Vorbereitungs-Verfahrens durchgeführten DCB-Verfahren stellte sich heraus, daß die hiermit aufgebrachten Kupferschichten ausreichenden Halt am AlN-Substrat aufwiesen.

### Beispiel 3: Temperatur: 1275°C, Atmosphärenzusammensetzung: Umgebungsluft (23,06 Gew.-% O₂); Atmosphärendruck 4bar, Reaktionszeit: 10s

Bei Verwendung dieser Prozeßparameter ist eine Al₂O₃-Beschichtung mit Schichtstärken im Bereich zwischen 0,1 und 5µm entstanden. Es hat sich herausgestellt, daß auf solchen vergleichsweise dünnen Al₂O₃-Schichten Kupferschichten besonders homogen aufgebondet werden können.

Überraschenderweise wies ein dem erfindungsgemäßen Verfahren entsprechend oberflächlich oxidiertes AlN-Substrat desweiteren eine besonders gute Teilentladungsfestigkeit auf.

## Patentansprüche

1. Verfahren zur Vorbereitung eines AlN-Substrates auf die Verbindung mit einer Kupferschicht mittels eines Direct-Copper-Bonding- (DCB-)Verfahrens, wobei auf der mit der Kupferschicht zu verbindenden Oberfläche des AlN-Substrates Al₂O₃ durch Erhitzen des AlN-Substrates in sauerstoffhältiger Atmosphäre gebildet wird, in welcher Atmosphäre ein Sauerstoff-Überangebot hergestellt wird, **dadurch gekennzeichnet, daß** das Sauerstoff-Überangebot durch Setzen einer sauerstoffhältigen Atmosphäre unter Überdruck, vorzugsweise im Bereich zwischen 1,2 und 10 bar, hergestellt wird.

2. Verfahren nach Anspruch **1, dadurch gekennzeichnet, daß** in die Atmosphäre O₂ zugegeben wird oder daß die Atmosphäre zur Gänze durch O₂ gebildet wird.

3. Verfahren nach Anspruch 1, **dadurch gekennzeichnet, daß** in die Atmosphäre O₃ zugegeben wird oder daß die Atmosphäre zur Gänze durch O₃ gebildet wird.

4. Verfahren nach einem der Ansprüche 1 bis 3, **dadurch gekennzeichnet, daß** das AlN-Substrat für eine Zeitdauer zwischen 1 und 20 min erhitzt wird.

5. Verfahren nach einem der Ansprüche 1 bis 3, **dadurch gekennzeichnet, daß** das AlN-Substrat für eine Zeitdauer zwischen 1 und 20s erhitzt wird.

## Claims

1. A method for preparing an AIN (aluminium nitride) substrate for bonding with a copper layer by means of a Direct Copper Bonding (DCB) method, with Al₂O₃ being formed on the surface of the AIN substrate to be bonded with the copper layer by means of heating the AIN substrate in an oxygenic atmosphere, in which atmosphere an excessive supply of oxygen is produced, **characterized in that** the excessive supply of oxygen is produced by setting an oxygenic atmosphere under pressure above atmospheric, preferably in the region of between 1.2 and 10 bars.

2. A method as claimed in claim 1, **characterized in that** O₂ is added to the atmosphere or that the atmosphere is formed entirely by O₂.

3. A method as claimed in claim 1, **characterized in that** O₃ is added to the atmosphere or that the atmosphere is formed entirely by O₃.

4. A method as claimed in one of the claims 1 to 3, **characterized in that** the AlN substrate is heated for a period of between 1 and 20 minutes.

5. A method as claimed in one of the claims 1 to 3, **characterized in that** the AlN substrate is heated for a period of between 1 and 20 seconds.

## Revendications

1. Procédé pour la préparation d'un substrat en nitrure d'aluminium en vue de l'assemblage avec une couche de cuivre au moyen d'un procédé de métallisation directe au cuivre (DCB, Direct Copper Bonding), dans lequel de l'Al₂O₃ est formé sur la surface du substrat en nitrure d'aluminium à assembler avec la couche de cuivre par chauffage du substrat en nitrure d'aluminium dans une atmosphère contenant de l'oxygène dans laquelle un excédent d'oxygène est créé, **caractérisé en ce que** l'excédent d'oxygène est produit par établissement d'une surpression, de préférence de l'ordre de 1,2 à 10 bars, dans une atmosphère contenant de l'oxygène.

2. Procédé selon la revendication 1, **caractérisé en ce que** de l'O₂ est ajouté à l'atmosphère ou l'atmosphère est entièrement composée d'O₂.

3. Procédé selon la revendication 1, **caractérisé en ce que** de l'O₃ est ajouté à l'atmosphère ou l'atmosphère est entièrement composée d'O₃.

4. Procédé selon l'une quelconque des revendications 1 à 3, **caractérisé en ce que** le substrat en nitrure d'aluminium est chauffé pendant une durée de 1 à 20 minutes.

5. Procédé selon l'une quelconque des revendications 1 à 3, **caractérisé en ce que** le substrat en nitrure d'aluminium est chauffé pendant une durée de 1 à 20 secondes.
